Europäisches Patentamt

European Patent Office

Office européen des brevets

(19)

(11) **EP 1 480 084 A1**

(12) **EUROPEAN PATENT APPLICATION**

(43) Date of publication:
**24.11.2004 Bulletin 2004/48**

(51) Int Cl.⁷: **G03F 7/20**

(21) Application number: **04076171.0**

(22) Date of filing: **16.04.2004**

| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (72) Inventors:<br>• **Koolen, Armand Eugene Albert**<br>  **5658 HD Eindhoven (NL)**<br>• **Maul, Manfred**<br>  **75434 Aalen (DE)**<br>• **Knols, Edwin Wilhelmus Marie**<br>  **5622 GE Eindhoven (NL)** |
|---|---|
| (30) Priority: **17.04.2003 EP 03076142** | |
| (71) Applicant: **ASML Netherlands B.V.**<br>**5504 DR Veldhoven (NL)** | (74) Representative: **Winckels, Johannes Hubertus F.**<br>**Vereenigde**<br>**Nieuwe Parklaan 97**<br>**2587 BN Den Haag (NL)** |

(54) **Lithographic apparatus and device manufacturing method**

(57)    A lithographic projection apparatus comprising:

a radiation source for providing a projection beam of radiation;
a support structure for supporting patterning means, the patterning means serving to pattern the projection beam according to a desired pattern;
a substrate table for holding a substrate;
a projection system for projecting the patterned beam onto a target portion of the substrate;

said radiation source further comprising:

an illumination system for conditioning said beam of radiation so as to provide a conditioned radiation beam so as to be able to illuminate said patterning means; said illumination system defining a plane of entrance wherein said radiation beam enters said illumination system; and
a beam delivery system comprising redirecting elements for redirecting and delivering said projection beam from a radiation source to said illumination system. The lithographic projection apparatus is characterized in that the said beam delivery system comprises an imaging system for imaging said radiation beam from an object plane located at a distance from said plane of entrance to an image plane located near or at said plane of entrance. In this way the influence of laser pointing drift on both beam position and pointing drift at said entrance is highly decreased.

FIG 3

## Description

The present invention relates to a lithographic projection apparatus comprising:

- a radiation source for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;

said radiation source further comprising:

- an illumination system for conditioning said beam of radiation so as to provide a conditioned radiation beam so as to be able to illuminate said patterning means; said illumination system defining a plane of entrance wherein said radiation beam enters said illumination system; and
- a beam delivery system comprising redirecting elements for redirecting and delivering said projection beam from a radiation source to said illumination system.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation source may also include components operating according to any of these design types for directing, shaping or controlling the projection beam, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

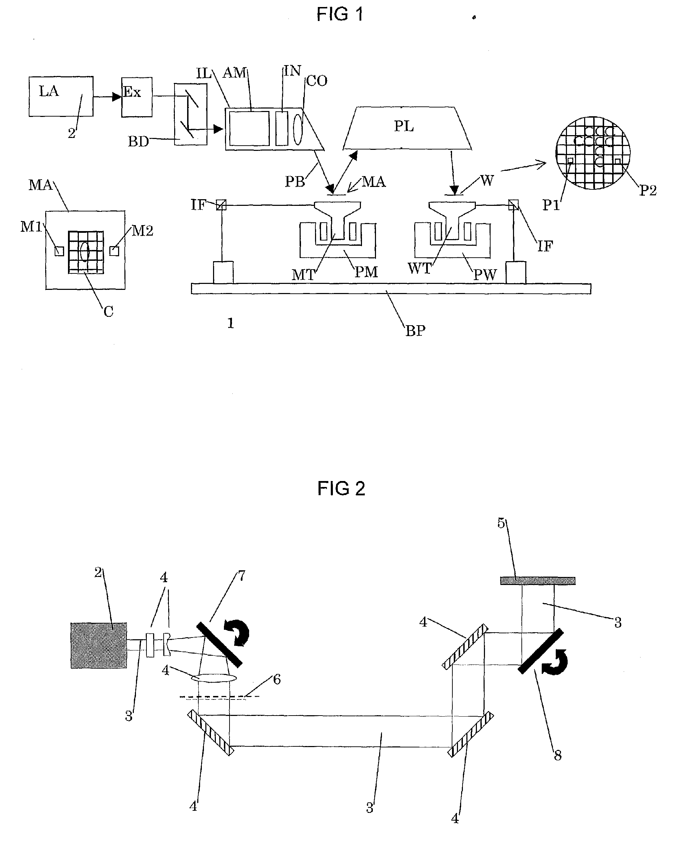

Prior art photolithographic systems generally comprise a radiation source located at a certain distance from the actual projection system. In most setups, the generators of radiation, such as laser systems or the like, are situated in another location, oftentimes even on a different floor in a building. A regular setup for such a lithographic system is a laser that is located on one floor of a building, and an illumination and projection system that is located on another floor. Small or large, such a geometrical distance introduces the need for a beam delivery system for transporting and delivering the beam from the radiation source to the location where the incident radiation is actually used in the photolithographic process, i.e. to an illumination system wherein the radiation beam is first conditioned so as to provide optimal illumination characteristics, and then projecting the beam in order to transfer a lithographic pattern from a patterning means, such as a mask, to a target material. The prior art beam delivery systems generally comprise a set of reflective mirrors, from which generally at least two mirrors are tiltable, one mirror located in the vicinity of the illumination system and one mirror located at a distance of the illumination system. An illustrative setup for such prior art beam control is for instance depicted in fig. 2.

Obviously, a reflection of a radiation beam in these tiltable mirrors (also referred to as steering mirrors) affect both the pointing direction of the beam and the position where the beam enters the illumination system. Specifically, a beam reflected by a tiltable mirror located at a relatively large distance from such illumination system, will, upon tilt thereof enter at a displaced position into the illumination system, where the deviation in pointing direction of the beam will remain relatively small. In contrast, a beam reflected by a tiltable mirror located at a relatively small distance from such illumination system, will, upon rotation thereof enter at an almost unaltered location, where the pointing of the beam will vary quite dramatically. Thus, by tilting both steering mirrors, a controlled pointing direction and entrance position of the beam is possible, where both parameters can be tuned to an optimal setting.

These parameters are usually controlled relative to a plane of entrance wherein said radiation beam enters said illumination system, so that in a working photolithographic setup, exact requirements can be met as to inter alia the entering position of the radiation beam and the pointing of said beam at or near said plane of entrance. These characteristics are quite essential for providing a radiation beam that offers optimal illumination characteristics for attaining the desired minuteness of patterns that are produced in current systems.

However, such a coupling of pointing and position control by the steering mirror systems in the prior art photolithographic systems requires a relatively complicated correction method, which has to take into account that one correction in one degree of freedom induces a change of the radiation beam in another degree of freedom. Furthermore, current radiation sources almost generally suffer from intrinsic time variations in positional and directional output of radiation, which is for instance caused by the laser processes in the source itself. A drift in for instance laser pointing causes a relatively large drift in beam position. These variations also need to be detected and controlled in closed-loop control. Because the timeframe for these variations can range from picoseconds to seconds or even more, a huge band width is needed to control all errors. Therefore, it is very hard to have a robust closed-loop correction for these effects. Hence, a need exists to provide a lithographic projection apparatus which is less sensitive to such coupling of direction and positional alignment variations and radiation source imperfections.

Furthermore, it has been found that in current systems a change in position, i.e. a translation of the beam in transversal direction, induces a relative large impact on relevant illumination parameters such as uniformity and angular distribution of the beam on reticle level. Therefore it is desired to obtain a maximum control on the entrance position of the beam.

Hence, the invention has as an object to provide a lithographic system wherein variations of the radiation source have a less serious effect on these parameters and wherein a coupling between the position and pointing parameters of the radiation beam parameters is ultimately absent.

In accordance with the invention, the photolithographic system according to the features of the preamble is characterized in that the beam delivery system comprises an imaging system for imaging said radiation beam from an object plane located at a distance from said plane of entrance to an image plane located near or at said plane of entrance.

In this way, a translational effect by a variation in the pointing direction of the beam, even located at a certain physical distance of the illumination system, is annihilated by the imaging system, which effectively transfers and images pointing and position properties of the beam from the object plane to the image plane. Therefore, a tilt of the beam in the object plane does not lead to a translation near the plane of entrance, since the object plane is imaged and no translation occurs. By a suitable combination of imaging system parameters obviously the distance of the object to image plane can be controlled and the magnification of the object beam. Preferably, said imaging system is a 1X imaging system.

Said imaging system preferably comprises a pair of lenses, each lens of said pair having a focal distance of ¼ times said distance from said object plane to said image plane. Such an imaging system leads to a magnification of one. By such an imaging system arrangement, a complete uncoupling of pointing direction and position of the beam is possible as will be explained below.

By the photolithographic system according to the invention a complete uncoupling of tilt and translation occurs when a tiltable mirror is located in an object plane of said imaging system. It is then possible to control the position of the beam by translatable mirrors, that is, in a system wherein said beam delivery system comprises at least one translatable mirror for translating said projection beam in a at least one direction transverse to a beam direction.

Although the pointing direction of said beam is controllable by a plurality of tiltable mirrors each controlling different a rotation about different rotation axes, preferably, said mirror is tiltable in two different directions. Furthermore, said mirror may be translatable, in order to control at least one direction of movement of the beam for controlling the position of said beam.

The invention also relates to a device manufacturing method comprising the steps of: providing a substrate that is at least partially covered by a layer of radiation-sensitive material; providing a projection beam of radiation using a radiation source; delivering said projection beam from said radiation source to said illumination system; conditioning said projection beam using an illumination system, said illumination system defining a plane of entrance wherein said radiation beam enters said illumination system; using patterning means to endow the conditioned projection beam with a pattern in its cross-section; and projecting the patterned beam of radiation onto a target portion of the layer of radiation-sensitive material. According to the invention, the method comprises the steps of imaging said radiation beam from an object plane located at a distance from said plane of entrance to an image plane located near or at said plane of entrance. In a preferred embodiment, the method comprises the steps of locating a tiltable mirror in an object plane of said radiation beam so as to control pointing direction of the beam at the plane of entrance; wherein the method further comprises the steps of reflecting said radiation beam by translatable mirrors, so as to control the beam position at the plane of entrance.

Embodiments of the invention will now be described, by way of example only, with reference to the accompanying schematic drawings in which corresponding reference symbols indicate corresponding parts, and in which:

Figure 1 depicts a lithographic projection apparatus according to an embodiment of the invention;

Figure 2 depicts a beam delivery system according to the prior art;

Figure 3 depicts a beam delivery system according to the invention;

Figure 4 depicts a detailed view of imaging a tilted light beam from an object plane to an image plane;

Figure 5 depicts a schematic perspective view of a first mirror configuration showing translatable mirrors;

Figure 6 depicts a schematic perspective view of a second mirror configuration showing translatable mirrors.

Embodiment 1.

Figure 1 schematically depicts a lithographic projection apparatus 1 according to a particular embodiment of the invention. The apparatus comprises:

- a radiation source Ex, BD, IL, for supplying a projection beam PB of radiation (e.g. light in the deep ultraviolet region). In this particular case, the radiation source also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e. g. a resistcoated silicon wafer) , and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. an excimer laser source) produces a beam of radiation. This beam is fed into an illumination system (illuminator) IL, either directly or after having traversed conditioning means, such as a beam expander Ex, for example and a beam delivery system BD as shown in Fig. 1. The illuminator IL may comprise adjusting means AM for setting the outer and/ or inner radial extent (commonly referred to as sigma-outer and sigma-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example) , but that it may also be remote from the lithographic projection apparatus, the radiation beam which it produces being led into the apparatus (e.g. with said beam delivery system) ; this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure 2 shows a typical prior art setup for a beam delivery system BD, wherein the radiation source 2 generates a laser beam 3 that is guided via multiple mirrors and other light guiding elements 4 to a plane of entrance 5 in the illuminator system depicted as IL in figure 1.

In fact, said plane of entrance is a quite mathematical construct; any plane may form a plane of entrance, even a plane located at a certain distance from the illumination system or a plane located in or even after the illumination system. Such a plane of entrance may serve as a reference plane defining a zero-base plane from which the beam is further guided and conditioned while keeping close control on relevant imaging parameters. Hence for the purpose of the invention, such plane is generally referred to as "plane of entrance", although the plane may be located at various other positions.

In a general setup and as a preferred embodiment, said plane of entrance is usually coincident or nearly coincident with a so-called DOE-element, which is an optical element that is usually part of the illumination system IL in figure 1. Close to this DOE-level, a beam measuring system (not illustrated) measures inter alia the beam position and pointing direction thereof. This information is required to correct the mirrors 7 and 8 on a regular basis. In current systems, such a correction is done in between subsequent exposure of two wafers. In addition, the laser drift in pointing and position may be estimated and incorporated in the control of steering mirrors 2.

In figure 2, a dashed line indicates the presence of a "beam rotation break" 6, which means, that the section before said break, i.e. the section from the laser 2 to the break 6, may be oriented in a different direction than the section from the break 6 up to the plane of entrance 5. This direction usually introduces a 90 ° difference in both polarization and laser beam 3 direction.

The steering mirrors of figure 1 are comprised of a "positioning" steering mirror 7 and a "pointing" steering mirror 8 depicted in figure 2. Both mirrors are in this example illustrated as mirrors than are rotatable in two directions (as indicated by the curved arrow sign), thereby providing a tilt in two transversal directions relative to the beam direction. Obviously, a rotation or tilt of the positioning mirror 7 introduces a translation of the beam 3 at the plane of entrance 5, conversely, a rotation of the pointing mirror 8 introduces a change in the pointing direction of the beam near or at the plane of entrance 5. Evidently, the positioning mirror also introduces a slight change in the pointing direction of the beam and the pointing mirror introduces a slight translation of the beam, hence the translational and pointing effects of the mirrors 7 and 8 are coupled.

It has been found that a predominant factor to the uniformity and angular distribution budget on reticle level is due to laser pointing drift. In this respect, uniformity is related to the spatial distribution of the radiation at reticle level. However, an unwanted position shift of the laser beam at the illuminator entrance also leads to unwanted changes in the angular distribution of the radiation, and differs this distribution from the angular distribution of the unshifted beam. Hence, small variations $\Delta\alpha$ in the pointing direction of the laser at a distance away from the DOE-level are magnified by the distance L between the laser and the Doe: a transversal translation of the beam 3 occurs of magnitude $L\Delta\alpha$. Obviously, such a translation cannot be ignored and depending on the time scale this drift occurs, it is quite difficult to compensate this effect by closed-loop beam steering setup, where the beam measuring unit measures a deviation and a correction signal is generated to control the steering mirrors 7 and 8 in order to compensate such deviation.

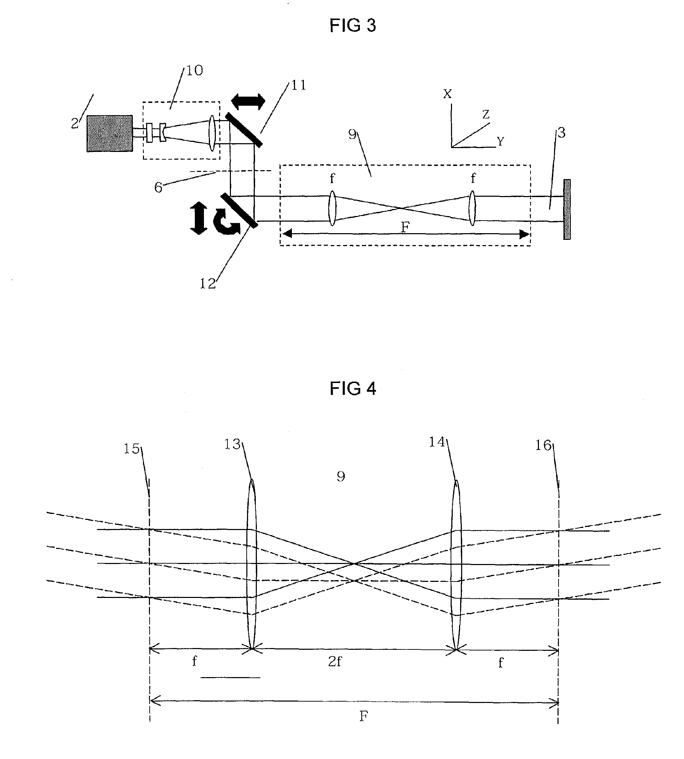

In the setup of fig. 3, the geometrical distance remains unaltered, but the optical distance a laser beam 3 travels from the laser to the illumination system is reduced by introducing an imaging system 9 in the beam delivery path. Although the skilled artisan will appreciate that the imaging system may comprise various alternatives, a basic solution is illustrated by the embodiment depicted in fig. 3 . This embodiment comprises two positive lenses introducing an object to image distance F and a magnification factor M. Thus, the optical distance is now reduced by distance F of the imaging system and the geometrical distance is unaltered.

In the embodiment, there is depicted a laser 2. After the laser 2, a beam expander unit 10 is placed for defining an appropriate shape of the laser beam. In this example, the unit 10 comprises a conventional beam expander optical system. After the beam expander unit 10 a translatable mirror 11 is placed at a 45 ° angle with the beam direction. Hence, the beam is reflected at an angle of 90 ° towards the section break 6. After the break 6 the system is oriented along the Y axis as is indicated by the reference coordinate system.

The section before the break 6 is oriented in the Z-direction, although for illustrating purposes depicted as lying in the Y direction.

In this configuration, a translation of mirror 11 in the Z-direction introduces a translation in Z-direction. The laser beam 3, reflects in a second translatable mirror 12, oriented at a 45° angle with the beam direction, again reflecting the beam at an angle of 90 ° in the Y-direction. A small translation of the mirror 12 in the X direction now introduces a translation in X-direction. Hence a combination of translation of both mirrors 11 and 12 moves the beam in a X-Z plane generally perpendicular to the beam direction Y. Furthermore, the beam may be reflected by a tiltable mirror, which in the embodiment preferably is the mirror 12 that is also translatable. In this way, small deviations in the direction of the beam may be compensated by rotating the mirror. Off course, when the mirror is not located near the object plane of the image system, such a rotation will introduce a translation of the beam as well, as explained with reference to figure 2.

In figure 4 a detailed illustration is given of the imaging characteristics of a 1X imaging system 9 preferably used by the invention.

The imaging system 9 of the preferred embodiment comprises a pair of identical positive lenses 13, 14 having focal distance f and spaced at a distance of 2f.

In this system, an object plane 15 located at a distance f in front of lens 13 is imaged at a distance f after lens 14. Hence, the optical distance of the beam is reduced by an amount of 4f. It is noted that the 1X imaging is relatively insensitive to the exact position of both lenses, provided that they are separated by a distance 2f.

The system 9 of figure 4 hence transfers pointing and position of the light beams in object plane 15 to exact inverted position and pointing direction in image plane 16. Therefore, a change in direction in the object plane does not result in a change in position in the image plane-effectively uncoupling the pointing and position characteristics of the laser beam 4. It is noted that a relative small deviation induced by pointing drift of the laser is now virtually eliminated by the system, since such a deviation does only lead to a very small, ultimately absent translation near the plane of entrance. Hence, the need for correction of pointing deviations is much smaller, since these deviations will not introduce a translation if the pointing deviations can be projected on the object plane of the imaging system 9.

By introduction of the imaging system 9 having an object to image distance of $F = 4f$ and magnification $M = 1$, a pointing deviation $\Delta\alpha$ now only introduces a translation of $\frac{\Delta\alpha(L - F)}{M}$

It will be appreciated that when the object to image distance is equal to the geometrical distance $L$, there is no translational deviation near the entrance plane of the illumination unit. In that case, beam position - and pointing control can be completely uncoupled. The steering and control of the beam pointing and position can therefore be considerably simplified and position errors due to laser pointing drift can be strongly attenuated, thereby increasing the stability of both uniformity and angular distribution of the radiation beam on reticle level.

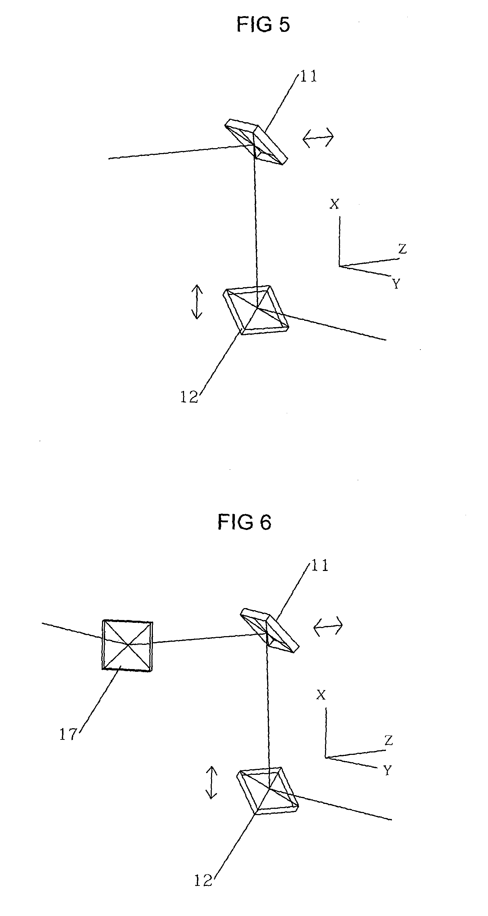

Figures 5 and 6 show two different perspective views of the mirror configuration depicted in figure 3 showing translatable mirrors 11 and 12.

In figure 5, a system comprising such a translatable mirror configuration shows an orthogonal bend, because the input beam (coming from a laser source) points in a different direction than the rest of the beam delivery system. To arrive at a system that is oriented in a generally longitudinal direction, figure 6 discloses a configuration, wherein a further mirror 17 reflects the beam in a desired longitudinal direction. Both solutions rotate both the laser beam aspect and its polarization, which can be rotated back in well known ways if required.

Whilst specific embodiments of the invention have been described above, it will be appreciated that the invention may be practiced otherwise than as described. In the embodiments, the imaging system is a 1X imaging system. Other magnifications may be introduced as well, as well as other beam shaping and conditioning prior to entering the illumination unit. The description is not intended to limit the invention.

## Claims

1. A lithographic projection apparatus comprising:

   - a radiation source for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate;

   said radiation source further comprising:

   ○ an illumination system for conditioning said beam of radiation so as to provide a conditioned radiation beam so as to be able to illuminate said patterning means; said illumination system defining a plane of entrance wherein said radiation beam enters said illumination system; and
   ○ a beam delivery system comprising redirecting elements for redirecting and delivering said projection beam from a radiation source to said illumination system

   **characterized in that**

   - said beam delivery system comprises an imaging system for imaging said radiation beam from an object plane located at a distance from said plane of entrance to an image plane located near or at said plane of entrance.

2. A lithographic projection apparatus according to claim 1, wherein said imaging system is a 1X imaging system.

3. A lithographic projection apparatus according to claim 2, wherein said imaging system comprises a pair of lenses, each lens of said pair having a focal distance of ¼ times said distance from said object plane to said image plane.

4. A lithographic projection apparatus according to any of the preceding claims, wherein said beam delivery system comprises at least one translatable mirror for translating said projection beam in a at least one direction transverse to a beam direction.

5. A lithographic projection apparatus according to claim 4, wherein two translatable mirrors are positioned in subsequent positions of the beam delivery path, wherein a first mirror translates said beam in a first direction and a second beam translates said beam in a second direction, said first and second directions being transverse to each other and to said beam direction.

6. A lithographic projection apparatus according to claims 4-5, wherein said translatable mirror is placed in said object plane.

7. A lithographic projection apparatus according to any of the preceding claims, wherein a tiltable mirror is located in an object plane of said imaging system.

8. A lithographic projection apparatus according to claim 7, wherein said tiltable mirror is rotatable in two different directions.

9. A lithographic projection apparatus according to claim 7 or 8, wherein said tiltable mirror is translatable.

10. A device manufacturing method comprising the steps of:

   - providing a substrate that is at least partially covered by a layer of radiation-sensitive material;
   - providing a projection beam of radiation using a radiation source;
   - delivering said projection beam from said radiation source to said illumination system
   - conditioning said projection beam using an illumination system, said illumination system defining a plane of entrance wherein said radiation beam enters said illumination system;
   - using patterning means to endow the conditioned projection beam with a pattern in its cross-section; and

   - projecting the patterned beam of radiation onto a target portion of the layer of radiation-sensitive material

   **characterized in that** the method comprises the steps of

   - imaging said radiation beam from an object plane located at a distance from said plane of entrance to an image plane located near or at said plane of entrance.

11. A method according to claim 10, **characterized in that** the method comprises the steps of locating a tiltable mirror in an object plane of said radiation beam so as to control pointing direction of the beam at the plane of entrance; wherein the method further comprises the steps of reflecting said radiation beam by translatable mirrors, so as to control the beam position at the plane of entrance.

FIG 1

FIG 2

FIG 3

FIG 4

FIG 5

FIG 6

European Patent Office

**EUROPEAN SEARCH REPORT**

Application Number

EP 04 07 6171

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/038225 A1 (DIERICHS MARCEL ET AL) 27 February 2003 (2003-02-27)<br>* abstract; figures 1,6,7,9,10 *<br>* claims 1,2,11,17 *<br>* paragraph [0020] - paragraph [0022] *<br>* paragraphs [0067], [0069], [0077] *<br>* paragraph [0079] - paragraph [0087] * | 1,4-10 | G03F7/20 |
| E | EP 1 431 827 A (ASML NETHERLANDS BV) 23 June 2004 (2004-06-23)<br>* claims 1,10; figures 1-4 * | 1,10 | |
| A | DATABASE WPI<br>Section PQ, Week 200321<br>Derwent Publications Ltd., London, GB;<br>Class P34, AN 2002-156344<br>XP002275585<br>& TW 490 598 A (ASM LITHOGRAPHY BV)<br>11 June 2002 (2002-06-11)<br>* abstract * | 1-11 | |
| A,P | -& US 6 593 585 B1 (LOOPSTRA ERIK R ET AL) 15 July 2003 (2003-07-15)<br>* abstract; figures 1,2 *<br>* column 2, line 51 - column 4, line 26 *<br>* column 6, line 41 - column 8, line 23 * | | TECHNICAL FIELDS SEARCHED (Int.Cl.7)<br><br>G03F |
| A | US 2002/196416 A1 (SHIRAISHI NAOMASA) 26 December 2002 (2002-12-26)<br>* abstract; figures 16,22,31,37 *<br>* paragraphs [0141], [0150] *<br>* paragraph [0205] *<br>* paragraph [0209] * | 1-11 | |
| A | US 6 313 918 B1 (DE GROOT PETER ET AL) 6 November 2001 (2001-11-06)<br>* abstract; figure 14A *<br>* column 9, line 55 - column 10, line 30 *<br>* column 71, line 5 - column 76, line 2 * | 1-11 | |

The present search report has been drawn up for all claims

| Place of search | Date of completion of the search | Examiner |
|---|---|---|
| Munich | 24 September 2004 | Hagner, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**  EP 04 07 6171

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2004

| Patent document cited in search report | | Publication date | Patent family member(s) | | Publication date |
|---|---|---|---|---|---|
| US 2003038225 | A1 | 27-02-2003 | EP | 1262836 A1 | 04-12-2002 |
| | | | JP | 2003022967 A | 24-01-2003 |
| | | | US | 2004108467 A1 | 10-06-2004 |
| EP 1431827 | A | 23-06-2004 | EP | 1431824 A1 | 23-06-2004 |
| | | | EP | 1431827 A1 | 23-06-2004 |
| | | | JP | 2004200696 A | 15-07-2004 |
| | | | US | 2004150807 A1 | 05-08-2004 |
| TW 490598 | A | 11-06-2002 | EP | 1107068 A2 | 13-06-2001 |
| | | | JP | 2001351855 A | 21-12-2001 |
| | | | US | 2003168615 A1 | 11-09-2003 |
| | | | US | 6593585 B1 | 15-07-2003 |
| US 6593585 | B1 | 15-07-2003 | EP | 1107068 A2 | 13-06-2001 |
| | | | JP | 2001351855 A | 21-12-2001 |
| | | | TW | 490598 B | 11-06-2002 |
| | | | US | 2003168615 A1 | 11-09-2003 |
| US 2002196416 | A1 | 26-12-2002 | JP | 3148818 B2 | 26-03-2001 |
| | | | JP | 4180612 A | 26-06-1992 |
| | | | JP | 3268501 B2 | 25-03-2002 |
| | | | JP | 4180613 A | 26-06-1992 |
| | | | JP | 3049774 B2 | 05-06-2000 |
| | | | JP | 4225357 A | 14-08-1992 |
| | | | JP | 3049775 B2 | 05-06-2000 |
| | | | JP | 4225358 A | 14-08-1992 |
| | | | JP | 3049776 B2 | 05-06-2000 |
| | | | JP | 4225359 A | 14-08-1992 |
| | | | JP | 3049777 B2 | 05-06-2000 |
| | | | JP | 4225514 A | 14-08-1992 |
| | | | US | 2002033936 A1 | 21-03-2002 |
| | | | US | 5638211 A | 10-06-1997 |
| | | | DE | 69132120 D1 | 25-05-2000 |
| | | | DE | 69132120 T2 | 21-09-2000 |
| | | | EP | 0486316 A2 | 20-05-1992 |
| | | | EP | 0967524 A2 | 29-12-1999 |
| | | | US | 2002101572 A1 | 01-08-2002 |
| | | | US | 2003043356 A1 | 06-03-2003 |
| | | | US | 6211944 B1 | 03-04-2001 |
| | | | US | 6252647 B1 | 26-06-2001 |
| | | | US | 2004080733 A1 | 29-04-2004 |
| | | | US | 6233041 B1 | 15-05-2001 |
| | | | US | 6636293 B1 | 21-10-2003 |
| US 6313918 | B1 | 06-11-2001 | US | 6252667 B1 | 26-06-2001 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 04 07 6171

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2004

| Patent document cited in search report | Publication date | Patent family member(s) | Publication date |
|---|---|---|---|
| US 6313918 B1 | | EP 1135668 A1 | 26-09-2001 |
| | | JP 2002525594 T | 13-08-2002 |
| | | TW 550376 B | 01-09-2003 |
| | | WO 0017605 A1 | 30-03-2000 |
| | | US 2004114152 A1 | 17-06-2004 |
| | | US 6631004 B1 | 07-10-2003 |